# EUROPEAN PATENT SPECIFICATION

(11) **EP 1 695 352 B1**
(45) Date of publication and mention of the grant of the patent: **08.12.2010**
(21) Application number: 04820020.8
(22) Date of filing: 12.11.2004
(51) Int. Cl.: G11C 11/22

(54) **METHOD AND APPARATUS TO IMPROVE MEMORY PERFORMANCE**
VERFAHREN UND VORRICHTUNG ZUR VERBESSERUNG DER SPEICHERLEISTUNGSFÄHIGKEIT
PROCEDE ET APPAREIL POUR AMELIORER LES PERFORMANCES D'UNE MEMOIRE

(30) Priority: 26.11.2003 US 722813
(43) Date of publication of application: 30.08.2006
(73) Proprietor: Intel Corporation, Santa Clara, CA 95052 (US)
(72) Inventor: LUEKER, Jonathan, Portland, OR 97229 (US); FABER, Robert, Hillsboro, OR 97124 (US); ISENBERGER, Mark, Corrales, NM 87048 (US)
(74) Representative: Dunlop, Hugh Christopher
(86) International application number: PCT/US2004/037773
(87) International publication number: WO 2005/055242

(56) References cited:
- WO-A1-03/021601
- US-A- 5 367 484
- US-A1- 2002 149 986
- US-A1- 2003 058 681
- US-A1- 2003 147 269
- US-B1- 6 201 731
- US-B1- 6 594 183

## Description

### BACKGROUND

Programmable memories are known. For example, US 5,367,484 discloses a programmable high endurance block for an EEPROM device. US 6,594,183 discloses a wear levelling technique for flash EEPROM systems. US 2002/0149986 discloses a dynamic refresh for a flash memory, in which data blocks are shifted cyclically among sectors in an array.

Ferroelectric memories are also known. For example, US 6,201,731 discloses an electronic memory with a disturb prevention circuit. US 2003/0147269 discloses a memory device including a cross point type ferroelectric memory and a randomly accessible write back type cache memory. US 2003/0058681 discloses a mechanism for efficient wearout counters in a destructive readout memory. WO 03/021601 discloses a non-volatile memory device comprising an electrically polarizable dielectric memory material.

In some memories, it may take several milliseconds or microseconds to perform a read cycle, i. e. , to read information from a location in memory.

Reducing the time it takes to perform a read cycle may improve the memory performance as may be measured in terms of memory operations per second.

In order to improve memory performance, system designers are continually searching for alternate ways to read memories.

Thus, there is a continuing need for alternate ways to read information from a memory.

### BRIEF DESCRIPTION OF THE DRAWINGS

The subject matter regarded as the invention is particularly pointed out and distinctly claimed in the concluding portion of the specification in particular in claims 1, 8 and 16. The present invention, however, both as to organization and method of operation, together with objects, features, and advantages thereof, may best be understood by reference to the following detailed description when read with the accompanying drawings in which:
FIG.1 is a diagram illustrating a portion of a ferroelectric memory cell;
FIG. 2 is a graph of the polarization versus voltage properties of a ferroelectric cell ;
FIG. 3 is a block diagram of a ferroelectric memory device;
FIG. 4 is a flow diagram illustrating a method to read information stored in a destructive read memory in accordance with one embodiment of the present invention;
FIG. 5 is a flow diagram illustrating a method to write information to a memory in accordance with one embodiment of the present invention; and
FIG. 6 is a block diagram illustrating a portion of a computing system in accordance with an embodiment of the present invention.

It will be appreciated that for simplicity and clarity of illustration, elements illustrated in the figures have not necessarily been drawn to scale. For example, the dimensions of some of the elements are exaggerated relative to other elements for clarity. Further, where considered appropriate, reference numerals have been repeated among the figures to indicate corresponding or analogous elements.

### DETAILED DESCRIPTION

In the following detailed description, numerous specific details are set forth in order to provide a thorough understanding of the present invention. However, it will be understood by those skilled in the art that the present invention may be practiced without these specific details. In other instances, well-known methods, procedures, components and circuits have not been described in detail so as not to obscure the present invention.

In the following description and claims, the terms "include" and "comprise," along with their derivatives, may be used, and are intended to be treated as synonyms for each other. In addition, in the following description and claims, the terms "coupled" and "connected," along with their derivatives, may be used. It should be understood that these terms are not intended as synonyms for each other. Rather, in particular embodiments, "connected" may be used to indicate that two or more elements are in direct physical or electrical contact with each other. "Coupled" may mean that two or more elements are in direct physical or electrical contact. However, "coupled" may also mean that two or more elements are not in direct contact with each other, but yet still co-operate or interact with each other.

In the following description and claims, the term "data" may be used to refer to both data and instructions. In addition, the term "information" may be used to refer to data and instructions.

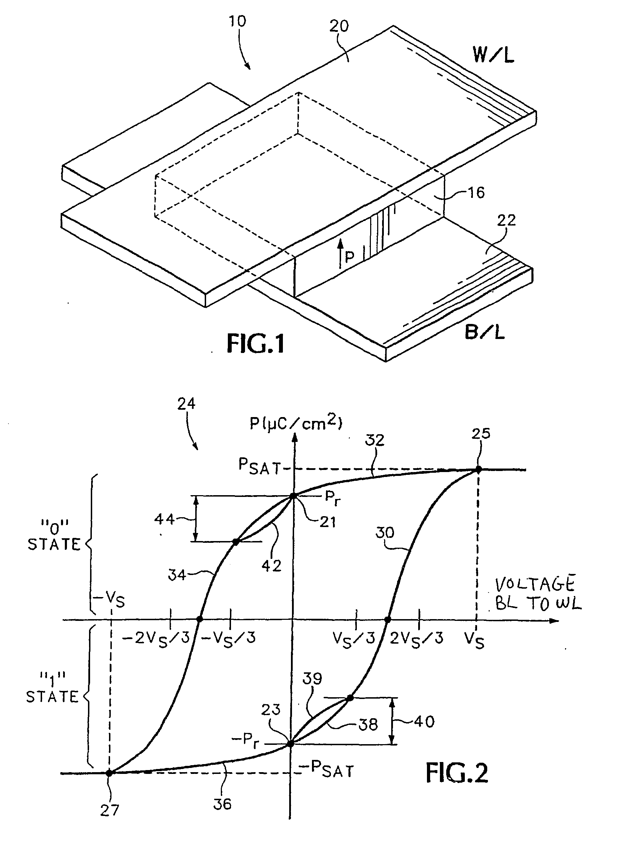

FIG. 1 is a diagram illustrating a portion of a ferroelectric memory cell 10 that may be used in embodiments of the present invention. Ferroelectric memory is a type of nonvolatile memory that utilizes the ferroelectric behavior of certain materials to retain data in a memory device in the form of positive and negative polarization, even in the absence of electric power. A ferroelectric material 16 may contain domains of similarly oriented electric dipoles that retain their orientation unless disturbed by some externally imposed electric force. The polarization of the material characterizes the extent to which these domains are aligned. The polarization can be reversed by the application of an electric field of sufficient strength and polarity.

Ferroelectric material 16 may be a ferroelectric polymer polarizable material, and may also be referred to as a ferroelectric polarizable material or a dipole ferroelectric material. In various embodiments, the ferroelectric polymer material may comprise a polyvinyl fluoride, a polyethylene fluoride, a polyvinyl chloride, a polyethylene chloride, a polyacrylonitrile, a polyamide, copolymers thereof, or combinations thereof. Another example of a ferroelectric material may include a ferroelectric oxide material.

A ferroelectric material 16 having a polarization P may be located between a conductive word line 20 and a conductive bit line 22. An electric field may be applied to the ferroelectric cell by applying an electric potential (voltage) between the word line (WL) and the bit line (BL) so as to effect changes in the polarization of the ferroelectric material.

FIG. 2 shows a simplified hysteresis curve 24 that illustrates idealistically the polarization versus voltage properties of the ferroelectric cell of FIG. 1. When a positive voltage (e.g., V_{bit line} - V_{word line} > 0) of sufficiently large magnitude (shown here, for example, as Vs) is applied to the cell, all of the domains in the cell are forced to align, to the extent possible, in the positive direction, and the polarization P reaches the saturation polarization Psat at point 25 on the curve. A further increase in the voltage produces no further increase in the polarization because all of the domains are already aligned as far as possible in the direction of the electric field produced by the voltage between the word line and bit line. In one example, a positive voltage may be applied by applying Vs, e.g., about nine volts, to bit line 22 and applying about zero volts to word line 20. In other example, two non-zero positive voltages may be applied to bit line 22 and word line 20 to generate a positive voltage across material 16.

If the voltage is then reduced to zero (following path 32 to arrive at point 21), some of the domains switch their orientation (also referred to as rotating, flipping or reversing), but most of the domains retain their orientation. Thus, the ferroelectric material retains a remnant polarization Pr.

If a negative voltage of sufficiently large magnitude (shown here, for example, as -Vs) is then applied to the word line 20 relative to bit line 22 (following path 34 to point 27), all of the domains are forced to switch their orientation, and the polarization reaches the negative saturation level -Psat. Removing this negative voltage (following path 36 to point 23) allows some of the domains to switch, and the cell polarization reaches the negative remnant polarization -Pr, which it retains until it is disturbed again. If the positive voltage Vs is again applied to the cell (following path 30 to point 25), the domains once again switch their orientation, and the cell takes on the positive saturation polarization Psat.

For purposes of data storage, ferroelectric cell 10 is considered to be in the logic "0" (zero) state when the polarization P is positive (preferably at Pr), and the logic "1" (one) state when the polarization is negative (preferably at - Pr). The assignment of a logic "1" or logic "0" to a positive or negative polarization is arbitrary, and in other embodiments, opposite conventions may be used.

A certain amount of charge may be required to switch the polarity of a domain, so the further the polarization moves along the P axis in FIG. 2, the more domains that are switched and the more charge is required. Thus, the transition from the logic 1 state at point 23 to the logic 0 state at point 25 is accompanied by a substantial release of charge, whereas the transitio n from point 21 to 25 (no change of state) is accompanied by very little charge release.

This difference in charge release provides the fundamental principle for a "destructive" read of a ferroelectric cell. In some memory storage technologies, an operation to read data from a memory location may cause the data to be destroyed. This is sometimes referred to as a destructive read operation and may result from the type of storage media used or how the memory system is designed. Some nonvolatile memories for example have destructive read operations. Destruction of the data in a particular memory location may include erasing, clearing, resetting, and/or overwriting the memory location. In such memory devices, the data read may be written back after being read in order to behave in a nondestructive read memory device manner.

In one example, to perform a destructive read, a negative voltage sufficient to switch the polarization is applied to cell 10 while the charge released from the cell is observed. A large charge release indicates that the cell was a logic zero, whereas little or no charge release indicates that the cell was a logic one. The cell ends up in the one state, regardless of its state before the read operation. Thus, a cell that was in the zero state must then be rewritten as a zero if further data retention is required.

Ferroelectric materials also exhibit resilience, wherein a ferroelectric cell can return to its remnant polarization despite a small disturbance. For example, assuming a one state storage condition for a ferroelectric cell, as represented by remnant polarization position 23 of hysteresis curve 24, a small voltage disturbance of Vs /3 may provide a small polarization shift 40 along path 38. However, once the voltage is removed, domains of the ferroelectric cell may realign their orientations to that of the cell's overall orientation, as illustrated by return path 39 of hysteresis curve 24.

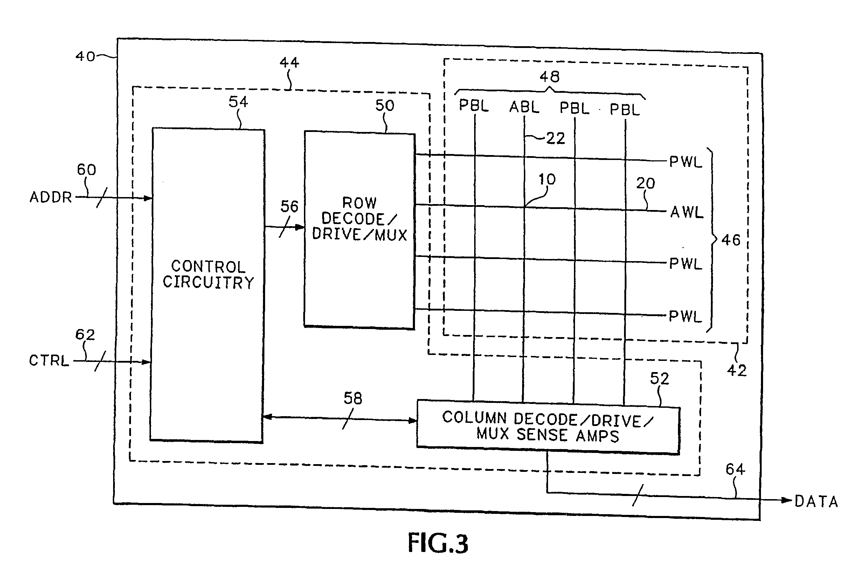

FIG. 3 is a block diagram illustrating a ferroelectric memory device 40 in accordance with an embodiment of the present invention. Memory device 40 includes a cross-point passive matrix memory array 42 having word lines 46 that cross bit lines 48. Ferroelectric material such as, for example, a ferroelectric polymer material, may be disposed between the word lines and bit lines to form ferroelectric cells at the intersections of word lines and bit lines. For example, a ferroelectric cell 10, such as that shown in FIG. 1, is located at the crossing of the word line identified as 20 and the bit line identified as 22 in FIG. 3. In this example, cell 10 is referred to as "active" because it identifies a specific cell that has been selected to read. The word line coupled to the active cell is identified as an active word line (AWL), whereas the remaining word lines are passive word lines (PWL). Likewise, the bit line coupled to the active cell is identified as the active bit line (ABL), whereas the remaining bit lines are passive bit lines (PBL). Passive word lines and bit lines may also referred to as unselected word lines and bit lines. Active word lines and bit lines may also be referred to as selected, addressed, or target word lines and bit lines.

When reading an active cell, a read or switching level voltage (-Vs) is applied to the active bit line 22. The read level voltage has a magnitude th at is defined as (V_{bitline} - V_{wordline}), and is sufficient to effect a polarization reversal of the active cell 10. Thus, the active cell is destructively read, wherein application of the read level voltage may switch the cell's polarization state. To restore the stored data after a polarization reversal, the data may be written back into the active cell. In some embodiments, memory array 42 may be partitioned or segmented into subarrays, and during a read cycle data may be written back to another memory cell as described below.

During the read, the passive bit lines and passive word lines may be driven with voltages that provide quiescent level electric fields across the passive ferroelectric cells. Quiescent level voltages may be defined in accordance with the resilient qualities of the ferroelectric cell, wherein polarization disturbances of the cells are kept within a recovery range. For example, in accordance with one embodiment of the present invention, the quiescent level may be set to a magnitude no greater than 1/3 the switching level voltage.

Referring again to FIG. 3, the word lines 46 may be driven by a row decoder block 50 that selects which of the word lines to drive as an active word line and which to drive as passive word lines in response to various control and buffered address signals 56 from control circuitry 54. The bit lines 48 may be driven and sensed by a column decoder block 52 that selects which of the bit lines to drive and as an active bit line and which to drive as passive bit lines in response to various control and buffered address signals 58 from the control circuitry. The column decoder block 52 also includes one or more sense amplifiers to facilitate reading of the active ferroelectric cell to provide output data 64.

The control circuitry 54 may include some or all of various components such as, for example, address buffers, read sequencers, data samplers or the like for controlling the overall operation of the memory device 40 in response to address signals 60 and control signals 62 from outside the device.

The row decoder block 50 may include various components such as, for example, row decoders, word line drivers, multiplexers, low-to-high voltage converters, etc. as may be required for the particular architecture employed in the memory device. For example, if the memory array 42 is divided into subarrays, then a multiplexer may be used to switch the word line drive signals between the subarrays. The column decoder block 52 may include various combinations of column decoders, bit line drivers, mulitplexers, sense amplifiers, write drivers, etc.

Taken together, the control circuitry, row decoder block, and column decoder block may form the peripheral circuitry 44 that interfaces the memory array 42 to the external world. However, the system of FIG. 3 is only exemplary, and various arrangements of peripheral circuitry may be employed without departing from the principles of present invention.

As discussed above, a ferroelectric polymer memory may store information by polarizing electric dipoles in a polymer film in one of two directions. In one embodiment, the polarization may be "flipped" by applying a specified drive voltage, e.g., Vs, across the polymer memory material, which is a polarizable material. A positive Vs may flip the polarization in one direction, and a negative voltage may flip the polarization in the opposite direction. The drive voltage of -Vs that is sufficient for switching the polarization state of a memory cell may be referred to as a read voltage and Vs may be referred to as a write voltage, although the scope of the present invention is not limited in this respect.

To write information, a write cycle may include an erase operation followed possibly by a write operation depending on the desired logic state in the memory cell. The erase operation may polarize the material in one direction, i.e., place the material in a specified or desired logic state ( e.g., store a logic "1"). Then, at a later point in time, the logic state stored in the memory cells may either remain at a logic "1" or may be selectively changed to a store a logic "0" by performing a write operation that may apply a voltage across the memory cell that is opposite in polarity compared to the voltage applied during the erase operation.

Also discussed above, reads may be destructive. To read information from a destructive read memory, a read cycle may include a destructive read operation and a subsequent write back operation. Since information stored at a particular physical address of the memory may be lost during the destructive read operation, the information may be written back to the memory to restore it. The destructive read operation may polarize the material in one direction, i. e., place the material in a specified or desired logic state (e.g. , store a logic"1"). Then, at a later point in time, the logic state stored in the memory cells may either remain at a logic "1" or may be selectively changed to a store a logic "0" by performing a write back operation that may apply a voltage across the memory cell that is opposite in polarity compared to the voltage applied during the destructive read operation. Accordingly, the write operation of a write cycle may be similar to the write back operation of a read cycle.

In one example, If information read from a requested address is written back to the same address, neighboring selected memory cells sharing the same word line or bit line as the selected memory cell may experience "disturbances" of Vs/3 when neighboring selected cells are written.

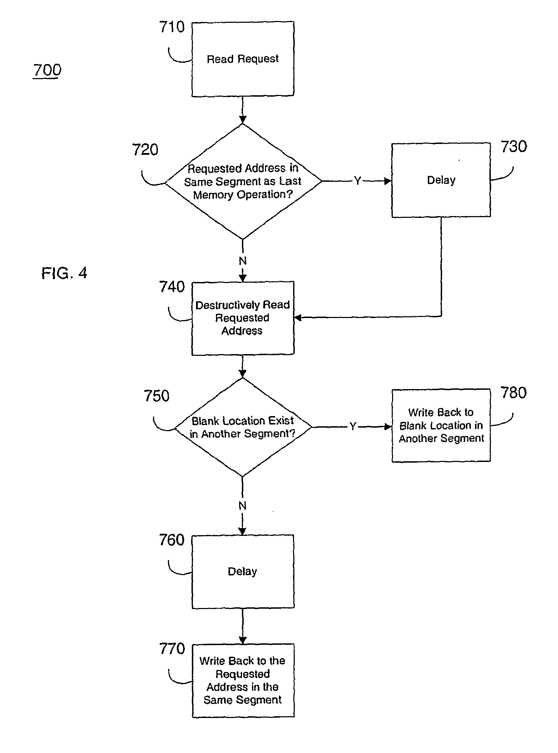

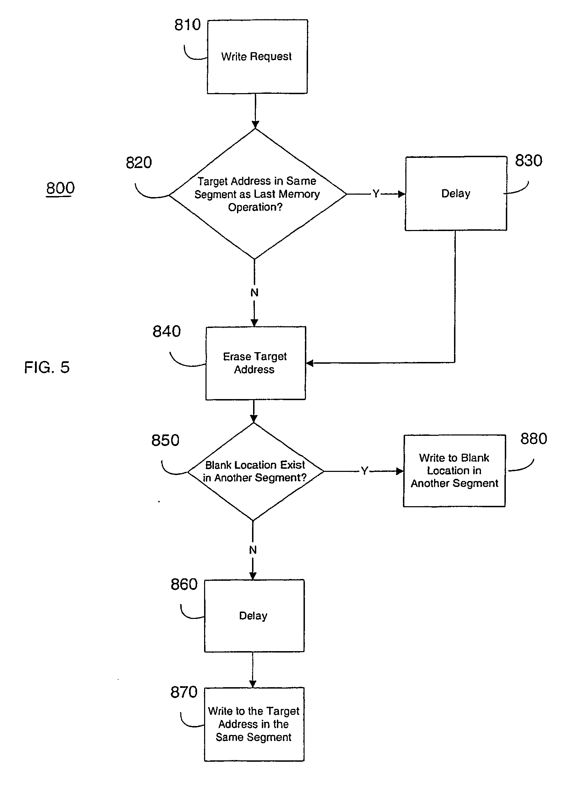

In a ferroelectric polymer memory, for a period of time immediately following a "flip" of polarization, the polymer memory cell may lose polarization if subjected to a disturb voltage. For example, this may happen when a read is followed by a write to the same cell, or when a write to one cell is followed by a write to a neighboring cell. As is illustrated below with reference to the methods of FIGS. 4 and 5, to avoid changes in polarization, delays or pauses may be used during reading and writing to a polymer memory. The delays may lengthen the time between flips and disturbances to avoid loss of data.

The amount of delay time used may depend on the electrode material (not shown) that is coupled to the polymer material of each memory cell. The interaction of the electrode material with the polymer memory material may result in a disturbance of the polarization in the memory cell if two memory operations are performed within a relatively short period of time.

Turning to FIG. 4, shown is a flow diagram illustrating a method 700 to read information stored in a destructive read memory in accordance with one embodiment of the present invention. Method 700 may begin with receiving a request to read information from a requested address or location in a memory (block 710). For example, control circuitry 54 of FIG. 3 may receive a request to read information from a requested address in memory array 42.

In one embodiment, the total memory capacity of a memory may be separated into at least two separately addressable memory segments. These segments may also be referred to as arrays or regions, and may be physically separated from each other.

Referring back to FIG. 4, after receiving the read request, it may be determined whether the requested address is in the same memory segment as the last, or most recent, memory operation (diamond 720). A memory operation may be a read, a write, or an erase operation, although the scope of the present invention is not limited in this respect. An erase operation may be part of a read cycle or a write cycle.

If it is determined that the requested address is in the same memory segment as the last memory operation, then a delay operation may be performed (block 730). In one example, a timer or counter may be used to delay the reading of information from the requested address for a predetermined amount of time after the prior memory operation was performed. After the predetermined amount of time has passed, then information may be destructively read from the requested address (block 740). In one example, a delay of 100 microseconds may be used between memory operations in the same segment.

If the requested address is not in the same memory segment as the last memory operation, then the destructive reading of information from the requested address may be performed immediately without delay (block 740). For example, the reading of information from the requested address may be performed during the successive clock cycle after it is determined that the requested address is not in the same memory segment.

After the information is destructively read from the requested address, then it may be determined whether a blank location exists in another segment, i.e., a segment other than the segment where the requested address is located (diamond 750). If a blank location does not exist in another segment, then a delay operation may be performed (block 760). A blank location may refer to a location that has been previously erased either by an erase operation or a destructive read operation. Although the scope of the present invention is not limited in this respect, in one example, a delay of 100 microseconds [may be used between memory operations in the same segment. After the predetermined amount of time has passed, then information may be written back to the requested address in the same segment (block 770).

If a blank location exists in another segment, then the write back operation may include writing back the information read from the requested address to the blank location in the other segment (block 780). Writing information to another segment of memory rather than same segment, may improve memory performance by avoiding delay operations. "Sneak" current may refer to a residual current that may flow in a segment after a write and may interfere with a subsequent read. By writing information to another segment rather than the same segment during a write back operation, this may allow "sneak" current to settle. In addition, by moving information to a new location during a write back operation, information that is accessed frequently may be moved around the chip, thereby leveling or evening out the wear patterns of the memory. This may extend the life of the memory. In summary, method 700 may allow for faster operation, reducing sneak current, and leveling of wear patterns, which may improve the speed, reliability, and lifetime of a destructive read memory.

In one embodiment, the total memory capacity of a polymer memory may be arranged into thirty-two separately addressable segments. The segments may be activated one at a time so that during a write, only the unaddressed cells within the active segment experience Vs/3 disturbances. Cells in the other thirty-one segments do not. Without such segmentation, a read may consist of a read + writeback with the same address being active for both. Thus, the cells of the active segment may be vulnerable to a "disturb." By segmenting the memory, the read and write back operations may be spatially separate in address space, not in time (as with pauses). This may be accomplished by reading one address and writing back to a blank location in another segment. Data is not lost, but rather moved to another segment in the memory. Because the write back operation is to a segment different from the destructive read operation, the cells that were flipped during the read may not be disturbed by the write back. Thus, faster speed or memory access times may be achieved without memory "disturbs."

Turning to FIG. 5, shown is a flow diagram illustrating a method 800 to write information to a memory in accordance with one embodiment of the present invention. Method 800 may begin with receiving a request to write information to a target address or location in a memory (block 810). For example, control circuitry 54 of FIG. 3 may receive a request to write information to a target address in memory array 42.

In one embodiment, the total memory capacity of a memory may be separated into at least two separately addressable memory segments. In various embodiments, segmentation of a memory into at least two memory segments may be achieved by physically separating word lines and bit lines, using decode circuitry, and/or using one or more voltage sources.

After receiving the read request, it may be determined whether the target address is in the same memory segment as the last, or most recent, memory operation (diamond 820). If it is determined that the requested address is in the same memory segment as the last memory operation, then a delay operation may be performed (block 830). In one example, a timer or counter may be used to delay the writing of information from the requested address for a predetermined amount of time after the prior memory operation was performed.

After the predetermined amount of time has passed, then the target address may be erased (block 840). In one example, a delay of 100 microseconds may be used between memory operations in the same segment. If the target address is not in the same memory segment as the last memory operation, then the erasing of the target address may be performed immediately without delay (block 840).

After erasing the target address, then it may be determined whether a blank location exists in another segment, i.e., a segment other than the segment where the targeted address is located (diamond 850). If a blank location does not exist in another segment, then a delay operation may be performed (block 860). After the delay operation, then information may be written to the target address in the same segment to satisfy the write request (block 870).

In some embodiments, both the erase and destructive read operations may polarize the material in one direction, i.e., place the material in a specified logic state ( e.g., store a logic "1"). Then, at a later point in time, the memory cells may either remain at a logic "1" or may be selectively changed to a logic "0" by performing a write back operation or a write operation.

If a blank location exists in another segment, then information may be written to the blank location in the other segment to satisfy the write request (block 880). Writing information to another segment of memory rather than same segment after an erase operation, may improve memory performance by avoiding delay operations.

Generally, embodiments described above provide a method to reduce memory disturbs in unselected cells and improve memory performance by partitioning a memory into at least two memory segments, creating blanks in one segment either by, e.g., a destructive read operation or an erase operation, and then, performing a write or a write back operation in another memory segment. By increasing the number of segments, it will be less likely that a delay operation will need to be performed. For example, in a memory with thirty-two physically separated memory segments, there is less than a 4% (1 out of 32) chance that a delay operation may be used.

In one embodiment, a read from a requested address may include reading all memory cells in a row of an array. This may be accomplished by applying a read pulse to a single word line, and applying zero volts to all bit lines of the array. Similarly, memory cells may be written to by writing to the full width of the array, which may refer to writing to all memory cells in a row of an array. In one embodiment, the size of the array may be 512 bytes, although the scope of the present invention is not limited in this respect.

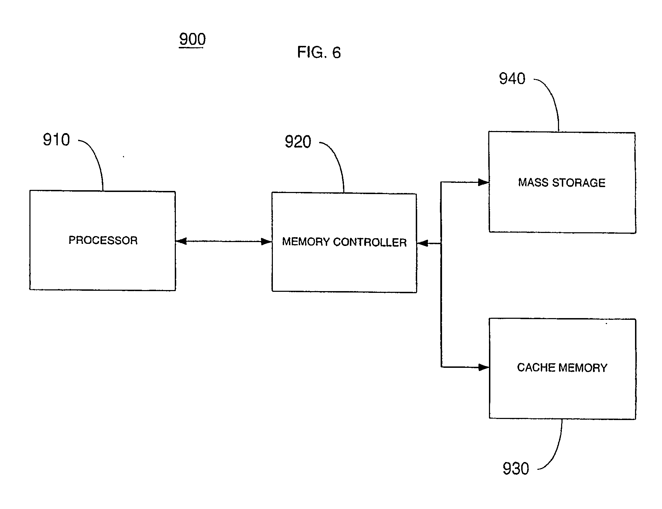

Turning to FIG. 6, shown is a block diagram of a computing system 900 in accordance with an embodiment of the present invention. As shown in FIG. 6, in one embodiment computing system 900 may include a processor 910, a memory controller 920, a cache memory 930, and a mass storage 940.

Processor 910 may be a general-purpose or special-purpose processor such as a microprocessor, microcontroller, application specific integrated circuit (ASIC), a programmable gate array (PGA), or the like.

In one embodiment, cache memory 930 include memory 40 as discussed above with reference to FIG. 3. In addition, in various embodiments, computing system 900 may be adapted to implement method 700 (FIG. 4) and/or method 800 (FIG. 5) discussed above.

In one embodiment, cache memory 930 may be a relatively large non-volatile disk cache memory adapted to cache information for mass storage 940. For example, cache memory 930 may be a ferroelectric polymer memory. To implement methods 700 or 800, cache memory 930 may be partitioned into at least two memory segments. Mass storage 940 may be a mass storage device such as, for example, a disk memory having a storage capacity of at least about one gigabyte. Mass storage 940 may be an electromechanical hard disk memory, an optical disk memory, or a magnetic disk memory, although the scope of the present invention is not limited in this respect. In one embodiment, cache memory 930 may have a storage capacity of at least about 500 megabytes and may include ferroelectric memory cells, wherein each cell includes a ferroelectric polymer material located between at least two conductive lines. The ferroelectric polymer material may be a ferroelectric polarizable material. In various embodiments, the ferroelectric polymer material may comprise a polyvinyl fluoride, a polyethylene fluoride, a polyvinyl chloride, a polyethylene chloride, a polyacrylonitrile, a polyamide, copolymers thereof, or combinations thereof.

In an alternate embodiment, cache memory 930 may be another type of plastic memory such as, for example, a resistive change polymer memory. In this embodiment, the plastic memory may include a thin film of polymer memory material sandwiched at the nodes of an address matrix. The resistance at any node may be altered from a few hundred ohms to several megohms by applying an electric potential across the polymer memory material to apply a positive or negative current through the polymer material to alter the resistance of the polymer material. Potentially different resistance levels may store several bits per cell and data density may be increased further by stacking layers.

Accordingly, as discussed above, methods, apparatuses, and systems have been provided to reduce memory disturbs and improve memory performance. In one embodiment, a method includes performing a read cycle in a memory, wherein the read cycle may include a destructive read operation and a write back operation. The memory may be a non-volatile ferroelectric polymer memory, although the scope of the present invention is not limited in this respect. The destructive read operation may include reading information from a first memory cell of the memory and the write back operation may include writing the information read from the first memory cell to a second memory cell of the memory if the second memory cell is available, e.g., erased or blank. The first memory cell may be located in a first segment of the memory and the second memory cell may be located in a second segment of the memory that is physically separated from the first segment. The method may further include writing the information read from the first memory cell back to the first memory cell if the second memory cell is not blank and after a predetermined amount of time has passed.

The method may further include delaying writing to, or reading from, the first memory cell for a predetermined amount of time if another memory operation to the first memory cell follows the destructive read operation. The other memory operation may be an erase operation that includes applying a voltage having a negative polarity and sufficient to switch the polarization of the first memory cell across the first memory cell to erase the memory cell to store a logic value of, e.g., a logic "1". Alternatively, the other memory operation may be a write operation that includes applying a positive voltage across the first memory cell to program the memory cell to store a logic "0" value.

In another embodiment, a method includes receiving a request to write information to a first location in a ferroelectric polymer memory. This method may future include writing the information only to a second location in the ferroelectric polymer memory and not writing the information to the first location in response to the request if the second location is available. The first location may be in a first array of the ferroelectric polymer memory and the second location may be in a second array of the ferroelectric polymer memory, wherein the first array is physically separated from the second array. The ferroelectric polymer memory may be a destructive read disk cache memory, although the scope of the present invention is not limited in this respect.

In another embodiment, an apparatus includes a memory having at least two memory arrays and a read circuit or memory controller coupled to the memory to perform a read cycle that includes a destructive read operation and a write back operation, wherein the destructive read operation includes reading information from a first memory cell of the memory and wherein the write back operation includes writing the information read from the first memory cell to a second memory cell of the memory. The read circuit may be a portion of peripheral circuitry 44 (FIG. 3) or memory controller 920 described above.

The memory of the apparatus may be a ferroelectric polymer memory, a ferroelectric oxide memory, or any other ferroelectric memory, although the scope of the present invention is not limited in this respect. In alternate embodiments, the memory may also be a non-ferroelectric memory. The memory may include at least two memory arrays, wherein each memory array may include ferroelectric memory cells that may include a layer of a ferroelectric polymer material having ferroelectric properties located between layers of electrodes.

While certain features of the invention have been illustrated and described herein, many modifications, substitutions, changes, and equivalents will now occur to those skilled in the art. It is, therefore, to be understood that the appended claims are intended to cover all such modifications and changes as fall within the scope of the invention.

## Claims

1. A method, comprising:
performing a read cycle (700) that includes a destructive read operation (740) and a write back operation (780); and
wherein the destructive read operation includes reading information from a first memory cell (10) of a memory (42),
**characterised by**
determining if a second memory cell is blank; and
writing the information read from the first memory cell to the second memory cell without delay if the second memory cell is blank, or writing the information read from the first memory cell back to the first memory cell after a predetermined amount of time has passed after the determination that the second memory cell is not blank.

2. The method of claim 1, wherein reading information includes: applying a read voltage across the first memory cell (10); and determining the amount of charge released from the first memory cell to determine the logic state of the information stored in the first memory cell.

3. The method of claim 1, wherein writing the information (780) includes applying a write voltage across the second memory cell.

4. The method of claim 1, further comprising: delaying writing to the first memory cell (10) for a predetermined amount of time.

5. The method of claim 4, wherein the writing to the first memory cell (10) includes applying a first voltage having a first polarity across the first memory cell, wherein the first voltage is sufficient to switch the polarization of the first memory cell.

6. The method of claim 1, wherein the destructive read operation (740) includes reading information from a first memory cell (10) of a non-volatile polymer ferroelectric disk cache memory (930).

7. The method of claim 1, wherein the first memory cell (10) is located in a first segment of the memory array (42) and the second memory cell is located in a second segment of the memory array that is physically separated from the first segment.

8. An article comprising a storage medium having stored thereon instructions, that, when executed by a computing platform (900), implement the method of claim 1.

9. The article of claim 8, wherein the instructions, when executed, further implement delaying writing to the first memory cell for a predetermined amount of time.

10. The article of claim 8, wherein the destructive read operation (740) includes reading information from a first memory cell (10) of a non-volatile polymer ferroelectric disk cache memory (930) and wherein writing the information (780) includes writing the information read from the first memory cell to a second memory cell if the second memory cell is blank.

11. The method of claim 1, wherein the step of performing a read cycle comprises:
receiving a request to write information to a first location (10) in a polymer memory; and
writing the information (780) to a second location in the polymer memory in response to the request.

12. The method of claim 11, further comprising determining whether the second location is available and wherein the writing (780) includes writing the information only to the second location in the polymer memory in response to the request.

13. The method of claim 11, wherein writing (780) includes writing the information to the second location and not writing the information to the first location in response to the request if the second location is available.

14. The method of claim 11, wherein the first location (10) is in a first array of the polymer memory (42) and the second location is in a second array of the polymer memory, wherein the first array is physically separated from the second array.

15. The method of claim 11, wherein the polymer memory (42) is a destructive read ferroelectric memory, and the first location (10) is in a first segment of the polymer memory and the second location is in a second segment of the polymer memory, wherein the first segment is physically separated from the second segment.

16. An apparatus, comprising:
a memory (930) having a memory array; and
a memory controller (920) coupled to the memory array (42) to perform a read cycle (700) that includes a destructive read operation (740) and a write back operation (780), wherein the destructive read operation includes reading information from a first memory cell (10) of the memory ,
**characterised in that** the controller is adapted to determine if a second memory cell is blank, and to write the information read from the first memory cell to the second memory cell without delay if the second memory cell is blank, or to write the information read from the first memory cell back to the first memory cell after a predetermined amount of time has passed after the determination that the second memory cell is not blank.

17. The apparatus of claim 16, wherein the first and second memory cells are ferroelectric memory cells comprising a non-volatile ferroelectric polymer material.

18. The apparatus of claim 17, wherein the non-volatile ferroelectric polymer material comprises a polyvinyl fluoride, a polyethylene fluoride, a polyvinyl chloride, a polyethylene chloride, a polyacrylonitrile, a polyamide, copolymers thereof, or combinations thereof.

19. A system, comprising the apparatus of claim 16,
wherein the memory is a disk cache memory (930), and the system further comprises:
a disk memory (940), wherein the disk cache memory is coupled to the disk memory.

20. The system of claim 19, wherein the storage capacity of the disk cache memory (930) is at least 500 megabytes and the storage capacity of the disk memory (940) is at least one gigabyte.

21. The system of claim 19, wherein the disk cache memory (930) is a non-volatile polymer memory.

22. The system of claim 19, wherein the disk cache memory (930) is a non-volatile ferroelectric memory.

23. The system of claim 19, wherein the first memory cell (10) is located in a first array of the memory and the second memory cell is located in a second array of the memory that is physically separated from the first array.

24. The method of claim 1, wherein the step of performing a read cycle comprises:
receiving a request to write information (780) to a first location (10) in a ferroelectric memory (42); and
writing the information to a second location in the ferroelectric memory in response to the request.

25. The method of claim 24, further comprising determining whether the second location is available and wherein the writing (780) includes writing the information only to the second location in the ferroelectric memory (42) in response to the request.

26. The method of claim 24, wherein writing (780) includes writing the information to the second location and not writing the information to the first location in response to the request if the second location is available, wherein the first location is in a first array of the ferroelectric memory (42) and the second location is in a second array of the ferroelectric memory, and wherein the first array is physically separated from the second array.

## Patentansprüche

1. Verfahren, welches das Folgende umfasst:
Durchführen eines Lesezyklus (700), welcher einen löschenden Lesevorgang (740) und einen Wiedereinspeicherungsvorgang (780) umfasst,
wobei der löschende Lesevorgang das Auslesen von Daten aus einer ersten Speicherzelle (10) eines Speichers (42) umfasst,
**gekennzeichnet durch das**
Bestimmen, ob eine zweite Speicherzelle leer ist, und
Einspeichern der Daten, die aus der ersten Speicherzelle ausgelesen wurden, in die zweite Speicherzelle ohne Zeitverzögerung, wenn die zweite Speicherzelle leer ist, oder Wiedereinspeichern der Daten, die aus der ersten Speicherzelle ausgelesen wurden, in die erste Speicherzelle, nachdem nach der Bestimmung, dass die zweite Speicherzelle nicht leer ist, eine vorgegebene Zeitspanne verstrichen ist.

2. Verfahren nach Anspruch 1, wobei das Auslesen von Daten das Folgende umfasst: Anlegen einer Lesespannung über die erste Speicherzelle (10) und Bestimmen der Ladungsmenge, die aus der ersten Speicherzelle freigesetzt wird, um den Logikzustand der Daten zu bestimmen, die in der ersten Speicherzelle gespeichert sind.

3. Verfahren nach Anspruch 1, wobei das Einspeichern der Daten (780) das Anlegen einer Einspeicherungsspannung über die zweite Speicherzelle umfasst.

4. Verfahren nach Anspruch 1, welches ferner das Folgende umfasst: Verzögern des Einspeicherns in die erste Speicherzelle (10) für eine vorgegebene Zeitspanne.

5. Verfahren nach Anspruch 4, wobei das Einspeichern in die erste Speicherzelle (10) das Anlegen einer ersten Spannung einer ersten Polarität über die erste Speicherzelle umfasst, wobei die erste Spannung ausreicht, um die Polung der ersten Speicherzelle umzuschalten.

6. Verfahren nach Anspruch 1, wobei der löschende Lesevorgang (740) das Auslesen von Daten aus einer ersten Speicherzelle (10) eines nichtflüchtigen polymeren ferroelektrischen Platten-Cache-Speichers (930) umfasst.

7. Verfahren nach Anspruch 1, wobei die erste Speicherzelle (10) in einem ersten Segment des Speicherfelds (42) angeordnet ist und die zweite Speicherzelle in einem zweiten Segment des Speicherfelds angeordnet ist, welches von dem ersten Segment physisch getrennt ist.

8. Gegenstand, welcher ein Speichermedium umfasst, auf dem Befehle gespeichert sind, die, wenn sie von einer Computerplattform (900) ausgeführt werden, das Verfahren nach Anspruch 1 realisieren.

9. Gegenstand nach Anspruch 8, wobei die Befehle, wenn sie ausgeführt werden, ferner eine Verzögerung des Einspeicherns in die erste Speicherzelle für eine vorgegebene Zeitspanne realisieren.

10. Gegenstand nach Anspruch 8, wobei der löschende Lesevorgang (740) ferner das Auslesen von Daten aus einer ersten Speicherzelle (10) eines nichtflüchtigen polymeren ferroelektrischen Platten-Cache-Speichers (930) umfasst, und wobei das Einspeichern der Daten (780) das Einspeichern der Daten, die aus der ersten Speicherzelle ausgelesen wurden, in eine zweite Speicherzelle umfasst, wenn die zweite Speicherzelle leer ist.

11. Verfahren nach Anspruch 1, wobei der Schritt des Durchführens eines Lesezyklus das Folgende umfasst:
Empfangen einer Anforderung, Daten an einer ersten Stelle (10) in einem Polymerspeicher einzuspeichern; und
Einspeichern der Daten (780) an einer zweiten Stelle in dem Polymerspeicher in Reaktion auf die Anforderung.

12. Verfahren nach Anspruch 11, welches ferner das Bestimmen umfasst, ob die zweite Stelle verfügbar ist, und wobei das Einspeichern (780) das Einspeichern der Daten nur an der zweiten Stelle in dem Polymerspeicher in Reaktion auf die Anforderung umfasst.

13. Verfahren nach Anspruch 11, wobei das Einspeichern (780) das Einspeichern der Daten an der zweiten Stelle und das Nicht-Einspeichern der Daten an der ersten Stelle in Reaktion auf die Anforderung umfasst, wenn die zweite Stelle verfügbar ist.

14. Verfahren nach Anspruch 11, wobei sich die erste Stelle (10) in einem ersten Feld des Polymerspeichers (42) befindet und die zweite Stelle in einem zweiten Feld des Polymerspeichers befindet, wobei das erste Feld von dem zweiten Feld physisch getrennt ist.

15. Verfahren nach Anspruch 11, wobei es sich bei dem Polymerspeicher (42) um einen ferroelektrischen Speicher zum löschenden Lesen handelt und sich die erste Stelle (10) in einem ersten Segment des Polymerspeichers befindet und die zweite Stelle in einem zweiten Segment des Polymerspeichers befindet, wobei das erste Segment von dem zweiten Segment physisch getrennt ist.

16. Vorrichtung, welche das Folgende umfasst:
einen Speicher (930), welcher ein Speicherfeld aufweist; und
eine Speichersteuerung (920), welche mit dem Speicherfeld (42) verbunden ist, um einen Lesezyklus (700) durchzuführen, der einen löschenden Lesevorgang (740) und einen Wiedereinspeicherungsvorgang (780) umfasst, wobei der löschende Lesevorgang das Auslesen von Daten aus einer ersten Speicherzelle (10) des Speichers umfasst,
**dadurch gekennzeichnet, dass** die Steuerung dafür geeignet ist, zu bestimmen, ob eine zweite Speicherzelle leer ist, und die Daten, die aus der ersten Speicherzelle ausgelesen wurden, in die zweite Speicherzelle ohne Zeitverzögerung einzuschreiben, wenn die zweite Speicherzelle leer ist, oder die Daten, die aus der ersten Speicherzelle ausgelesen wurden, wieder in die erste Speicherzelle einzuspeichern, nachdem nach der Bestimmung, dass die zweite Speicherzelle nicht leer ist, eine vorgegebene Zeitspanne verstrichen ist.

17. Vorrichtung nach Anspruch 16, wobei die erste und zweite Speicherzelle ferroelektrische Speicherzellen sind, welche ein nichtflüchtiges ferroelektrisches Polymermaterial umfassen.

18. Vorrichtung nach Anspruch 17, wobei das nichtflüchtige ferroelektrische Polymermaterial ein Polyvinylfluorid, ein Polyethylenfluorid, ein Polyvinylchlorid, ein Polyethylenchlorid, ein Polyacrylnitril, ein Polyamid, Copolymere derselben oder Kombinationen derselben umfasst.

19. System, welches die Vorrichtung nach Anspruch 16 umfasst,
wobei es sich bei dem Speicher um einen Platten-Cache-Speicher (930) handelt und das System ferner das Folgende umfasst:
einen Plattenspeicher (940), wobei der Platten-Cache-Speicher mit dem Plattenspeicher verbunden ist.

20. System nach Anspruch 19, wobei die Speicherkapazität des Platten-Cache-Speichers (930) mindestens 500 Megabyte beträgt und die Speicherkapazität des Plattenspeichers (940) mindestens ein Gigabyte beträgt.

21. System nach Anspruch 19, wobei es sich bei dem Platten-Cache-Speicher (930) um einen nichtflüchtigen Polymerspeicher handelt.

22. System nach Anspruch 19, wobei es sich bei dem Platten-Cache-Speicher (930) um einen nichtflüchtigen ferroelektrischen Speicher handelt.

23. System nach Anspruch 19, wobei sich die erste Speicherzelle (10) in einem ersten Feld des Speichers befindet und die zweite Speicherzelle in einem zweiten Feld des Speichers befindet, welches von dem ersten Feld physisch getrennt ist.

24. Verfahren nach Anspruch 1, wobei der Schritt des Durchführens eines Lesezyklus das Folgende umfasst:
Empfangen einer Anforderung, Daten an einer ersten Stelle (10) in einem ferroelektrischen Speicher (42) einzuspeichern (780); und
Einspeichern der Daten an einer zweiten Stelle in dem ferroelektrischen Speicher in Reaktion auf die Anforderung.

25. Verfahren nach Anspruch 24, welches ferner das Bestimmen umfasst, ob die zweite Stelle verfügbar ist, und wobei das Einspeichern (780) das Einspeichern der Daten nur an der zweiten Stelle in dem ferroelektrischen Speicher (42) in Reaktion auf die Anforderung umfasst.

26. Verfahren nach Anspruch 24, wobei das Einspeichern (780) das Einspeichern der Daten an der zweiten Stelle und das Nicht-Einspeichern der Daten an der ersten Stelle in Reaktion auf die Anforderung umfasst, wenn die zweite Stelle verfügbar ist, wobei sich die erste Stelle in einem ersten Feld des ferroelektrischen Speichers (42) befindet und die zweite Stelle in einem zweiten Feld des ferroelektrischen Speichers befindet, und wobei das erste Feld von dem zweiten Feld physisch getrennt ist.

## Revendications

1. Procédé, comprenant:
la réalisation d'un cycle de lecture (700) qui comprend une opération de lecture destructive (740) et une opération de réécriture (780) ; et
dans lequel l'opération de lecture destructive comprend des informations de lecture à partir d'une première cellule de mémoire (10) d'une mémoire (42),
**caractérisé par**
la détermination si une seconde cellule de mémoire est vide ; et
l'écriture des informations lues à partir de la première cellule de mémoire dans la seconde cellule de mémoire sans retard si la seconde cellule de mémoire est vide, ou réécriture des informations lues à partir de la première cellule de mémoire dans la première cellule de mémoire après qu'une quantité prédéterminée de temps se soit écoulée après la détermination que la seconde cellule de mémoire n'est pas vide.

2. Procédé selon la revendication 1, dans lequel les informations de lecture comprennent :
l'application d'une tension de lecture à travers la première cellule de mémoire (10) ; et la détermination de la quantité de charge libérée par la première cellule de mémoire pour déterminer l'état logique des informations stockées dans la première cellule de mémoire.

3. Procédé selon la revendication 1, dans lequel l'écriture des informations (780) comprend l'application d'une tension d'écriture à travers la seconde cellule de mémoire.

4. Procédé selon la revendication 1, comprenant en outre : le retard d'écriture dans la première cellule de mémoire (10) pendant une quantité prédéterminée de temps.

5. Procédé selon la revendication 4, dans lequel l'écriture dans la première cellule de mémoire (10) comprend l'application d'une première tension ayant une première polarité à travers la première cellule de mémoire, dans lequel la première tension est suffisante pour commuter la polarisation de la première cellule de mémoire.

6. Procédé selon la revendication 1, dans lequel l'opération de lecture destructive (740) comprend la lecture d'informations à partir d'une première cellule de mémoire (10) d'une mémoire cache de disque en polymère ferroélectrique non volatile (930).

7. Procédé selon la revendication 1, dans lequel la première cellule de mémoire (10) est située dans un premier segment du réseau de mémoire (42) et la seconde cellule de mémoire est située dans un second segment du réseau de mémoire qui est physiquement séparé du premier segment.

8. Article comprenant un support de stockage ayant stocké sur celui-ci des instructions, qui, lorsqu'elles sont exécutées par une plateforme de calcul (900), implémentent le procédé selon la revendication 1.

9. Article selon la revendication 8, dans lequel les instructions, lorsqu'elles sont exécutées, implémentent en outre un retard d'écriture dans la première cellule de mémoire pendant une quantité prédéterminée de temps.

10. Article selon la revendication 8, dans lequel l'opération de lecture destructive (740) comprend des informations de lecture à partir d'une première cellule de mémoire (10) d'une mémoire cache de disque en polymère ferroélectrique non volatile (930) et dans lequel l'écriture des informations (780) comprend l'écriture des informations lues à partir de la première cellule de mémoire dans une seconde cellule de mémoire si la seconde cellule de mémoire est vide.

11. Procédé selon la revendication 1, dans lequel l'étape de réalisation d'un cycle de lecture comprend :
la réception d'une demande pour écrire des informations dans un premier emplacement (10) dans une mémoire en polymère ; et
l'écriture des informations (780) dans un second emplacement dans la mémoire en polymère en réponse à la demande.

12. Procédé selon la revendication 11, comprenant en outre la détermination si le second emplacement est disponible et dans lequel l'écriture (780) comprend l'écriture des informations seulement dans le second emplacement dans la mémoire en polymère en réponse à la demande.

13. Procédé selon la revendication 11, dans lequel l'écriture (780) comprend l'écriture des informations dans le second emplacement et la non-écriture des informations dans le premier emplacement en réponse à la demande si le second emplacement est disponible.

14. Procédé selon la revendication 11, dans lequel le premier emplacement (10) est dans un premier réseau de la mémoire en polymère (42) et le second emplacement est dans un second réseau de la mémoire en polymère, dans lequel le premier réseau est physiquement séparé du second réseau.

15. Procédé selon la revendication 11, dans lequel la mémoire en polymère (42) est une mémoire ferroélectrique de lecture destructive, et le premier emplacement (10) est dans un premier segment de la mémoire en polymère et le second emplacement est dans un second segment de la mémoire en polymère, dans lequel le premier segment est physiquement séparé du second segment.

16. Appareil comprenant :
une mémoire (930) ayant un second réseau ; et
un dispositif de commande de mémoire (920) couplé au réseau de mémoire (42) pour réaliser un cycle de lecture (700) qui comprend une opération de lecture destructive (740) et une opération de réécriture (780), dans lequel l'opération de lecture destructive comprend des informations de lecture à partir d'une première cellule de mémoire (10) de la mémoire,
**caractérisé en ce que** le dispositif de commande est adapté pour déterminer si une seconde cellule de mémoire est vide, et pour écrire les informations lues à partir de la première cellule de mémoire dans la seconde cellule de mémoire sans retard si la seconde cellule de mémoire est vide, ou pour réécrire les informations lues à partir de la première cellule de mémoire dans la première cellule de mémoire après qu'une quantité prédéterminée de temps se soit écoulée après la détermination que la seconde cellule de mémoire n'est pas vide.

17. Appareil selon la revendication 16, dans lequel les première et seconde cellules de mémoire sont des cellules de mémoire ferroélectriques comprenant un matériau en polymère ferroélectrique non volatile.

18. Appareil selon la revendication 17, dans lequel le matériau en polymère ferroélectrique non volatile comprend un fluorure de polyvinyle, un fluorure de polyéthylène, un chlorure de polyvinyle, un chlorure de polyéthylène, un nitrile polyacrylique, un polyamide, des copolymères de ceux-ci, ou des combinaisons de ceux-ci.

19. Système, comprenant l'appareil selon la revendication 16,
dans lequel la mémoire est une mémoire cache de disque (930), et le système comprend en outre :
une mémoire de disque (940), dans lequel la mémoire cache de disque est couplée à la mémoire de disque.

20. Système selon la revendication 19, dans lequel la capacité de stockage de la mémoire cache de disque (930) est au moins 500 mégaoctets et la capacité de stockage de la mémoire de disque (940) est au moins un gigaoctet.

21. Système selon la revendication 19, dans lequel la mémoire cache de disque (930) est une mémoire en polymère non volatile.

22. Système selon la revendication 19, dans lequel la mémoire cache de disque (930) est une mémoire ferroélectrique non volatile.

23. Système selon la revendication 19, dans lequel la première cellule de mémoire (10) est située dans un premier réseau de la mémoire et la seconde cellule de mémoire est située dans un second réseau de la mémoire qui est physiquement séparé du premier réseau.

24. Procédé selon la revendication 1, dans lequel l'étape de réalisation d'un cycle de lecture comprend :
la réception d'une demande pour écrire des informations (780) dans un premier emplacement (10) dans une mémoire ferroélectrique (42) ; et
l'écriture des informations dans un second emplacement dans la mémoire ferroélectrique en réponse à la demande.

25. Procédé selon la revendication 24, comprenant en outre la détermination si le second emplacement est disponible et dans lequel l'écriture (780) comprend l'écriture des informations seulement dans le second emplacement dans la mémoire ferroélectrique (42) en réponse à la demande.

26. Système selon la revendication 24, dans lequel l'écriture (780) comprend l'écriture des informations dans le second emplacement et la non-écriture des informations dans le premier emplacement en réponse à la demande si le second emplacement est disponible, dans lequel le premier emplacement est dans un premier réseau de la mémoire ferroélectrique (42) et le second emplacement est dans un second réseau de la mémoire ferroélectrique, et dans lequel le premier réseau est physiquement séparé du second réseau.
